# EUROPEAN PATENT SPECIFICATION

(11) **EP 0 481 153 B1**
(45) Date of publication and mention of the grant of the patent: **12.02.1997**
(21) Application number: 90830462.9
(22) Date of filing: 16.10.1990
(51) Int. Cl.: H01L 21/336, H01L 29/772

(54) **Process for the accomplishment of power MOS transistors with vertical current flow**
Verfahren zur Herstellung von MOS-Leistungstransistoren mit vertikalem Strom
Méthode de fabrication de transistors MOS de puissance à courant vertical

(43) Date of publication of application: 22.04.1992
(73) Proprietor: CONSORZIO PER LA RICERCA SULLA MICROELETTRONICA NEL MEZZOGIORNO, 95121 Catania (IT); SGS-THOMSON MICROELECTRONICS S.r.l., 20041 Agrate Brianza (Milano) (IT)
(72) Inventor: Zambrano, Raffaele, I-84085 Mercato San Serverino (Salerno) (IT); Magro, Carmelo, I-95121 Catania (IT)
(74) Representative: Mittler, Enrico

(56) References cited:
- EP-A- 0 244 366
- GB-A- 2 156 151
- PATENT ABSTRACTS OF JAPAN vol. 13, no. 383 (E-811)(3731) August 24, 1989 & JP-A-1 132 167

## Description

The present invention relates to a process for manufacturing power MOS transistors with vertical current flow, both of the discrete type (VDMOS) and of the integrated type (say, monolithic circuits comprising a control circuit and a power stage).

A process according to the known art for manufacturing transistors of the abovementioned type, be they of the n channel type or of the p type, provides for steps of growth of an epitaxial layer of silicon with a low concentration of dopant of a first type of conductivity on a silicon substrate with a high concentration of dopant of the same type, field oxidation, masking and then ionic implantation and diffusion of a high concentration of a dopant of a second type of conductivity in said epitaxial layer for the creation of a high-doping body region, masking and then definition of active areas on the surface of said epitaxial layer, growth of gate oxide on said active areas, deposition and doping of polycrystalline silicon on the gate oxide, masking and then etching of the polycrystalline silicon and of the gate oxide outside a gate region, masking and then diffusion of a low concentration of dopant of the second type in low-doping body regions at the sides and under said gate region for the formation of a channel region, diffusion of a high concentration of dopant of the first type at the sides of said gate region for the formation of source regions, deposition of insulating oxide on the polycrystalline silicon, definition of contact areas, metallization of the entire surface, coverage of the metallization with glass or other passivating materials. There is moreover provided for the metallization of the rear of the substrate for the creation of a drain region.

If the final structure is analysed of a power MOS transistor obtained according to the abovementioned known art, it can be seen that there is on each side of the gate region a bipolar parasite transistor, which in the case of an n channel power transistor is of the NPN type, where the emitter is formed by the source region, the base is formed by the body region and the collector is formed by the epitaxial layer.

The metallization accomplished on the surface of the MOS transistor causes this parasite transistor to have the base in a condition of substantial short circuit with the emitter, albeit limited by the presence of internal resistances between the surface of the power transistor, where the short circuit actually occurs by means of the metallization, and the body region under the source, which constitutes the active base of the parasite transistor. Such resistances constitute the base extrinsic resistance of the parasite transistor.

Such resistances, as well as the gain of the parasite transistor, are low in the high-doping body regions, where the high doping causes an increase of the recombinations in said region and thus diminishes the possibility of the passage of current from the emitter to the collector, while they have a higher value in the body regions having a low dopant concentration.

The importance of having low gains and low resistances of the parasite transistor may be observed by taking into account that every time the rate of variation of the voltage applied across the MOS power transistor is sufficiently high, the capacitance current flowing through the extrinsic base resistance of the parasite transistor base can bias it and thus cause it to switch in an active region. In this case the power transistor shall have a breakdown voltage equal to that of the parasite transistor with its base not short circuited with the emitter, which is obviously lower than that otherwise typical of the power MOS transistor.

Thus the presence of the above parasite transistor has the effect of lowering the power MOS transistor's breakdown voltage or in any case that of reducing the switching speed.

A VDMOS device is evidently that much stronger the higher is the value of the rate of voltage variation which is necessary for this event to occur, and thus the lower are the parasite transistor gain and the value of its base extrinsic resistance.

A drawback of the known art relates to the fact that the high-doping body region and the channel region are defined by two distinct maskings. A consequence deriving therefrom is a natural misalignment between the high-doping body region and the polycrystalline silicon constituting the gate.

As a consequence of this misalignment, the penetration could occur of the high-doping body region in the channel region, where the increase of doping would cause a rise in the conduction threshold voltage, as well as a rise in the source-drain resistance of the device during the conduction step.

A further drawback of the known art is constituted by the greater junction depth of the high-doping body region with respect to that of the low-doping body region. Such a disparity does not allow the optimization of the source-drain resistance in conduction for a given breakdown voltage, as the source-drain resistance in conduction rises with the growth of the epitaxial layer's thickness, while the breakdown voltage is set by the minimum thickness of the epitaxial layer under the body region and is thus that much lower the higher is the iunction thickness in the high-doping body region.

EP-A-0 244 366 discloses a process according to the preamble of claim 1, further including formation of heavily doped body regions inside the lightly doped body regions before formation of source regions thereon.

GB-A-2156151 discloses a further process in which the source regions are formed simultaneously or after the heavily doped body regions.

The object of the present invention is to provide an improved process for manufacturing power MOS transistors with vertical current flow.

According to the invention such object is attained with a process as defined in claim 1, which differs from those of EP-A-0 244 366 and GB-A-2 156 151 in that the source regions are formed before the formation of the heavily doped body regions.

The process according to the invention essentially produces the following effects:
a) the alignment of the high-doping body regions with the gate region minimizes simultaneously the base extrinsic resistance and the gain of the bipolar parasite transistor associated with the power transistor;
b) the junction depth of the high-doping body regions is less than that of the Low-doping body regions; in this way the thickness of the epitaxial layer is minimised, and with it the resistance of the device during the conduction step is also minimised, which depends on the above minimum thickness;
c) the elimination of the photo-masking process for the creation of the high-doping regions determines a reduction in the production cost.

The features of the present invention shall be better understood by making reference, merely as a non-limiting example, to the enclosed drawings, wherein:
Fig.s 1 to 5 illustrate successive steps of the process according to EP-A-0 244 366;
Fig.s 6 and 7 illustrate steps according to the invention, which are alternative to those illustrated in Fig.s 3 and 4;
Fig.s 8 and 9 illustrate the dopant concentration profiles in the different regions of a power MOS transistor manufactured according to Fig.s 1 to 5 and 6 to 7, respectively.

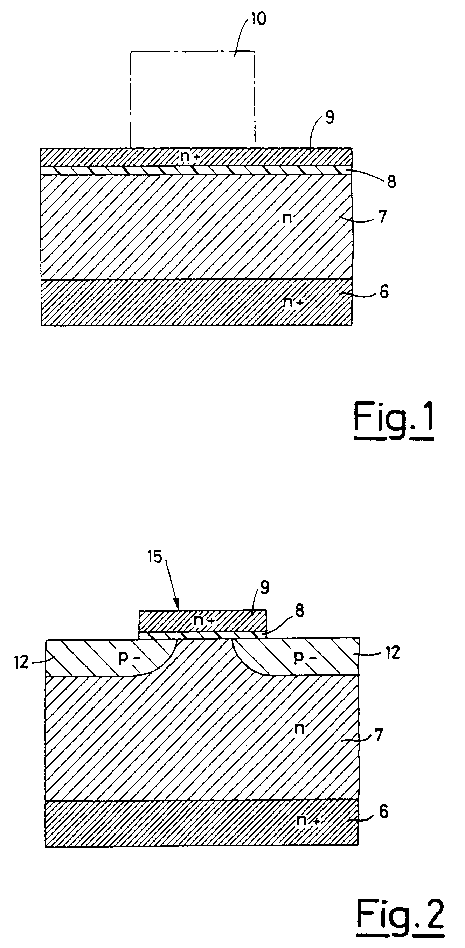

The prior art process illustrated in Fig.s 1 to 5, referring to the accomplishment of cells of power MOS n channel transistors with a vertical current flow, provides first of all for the growth on a substrate of silicon 6 having n+ doping (say, antimony) of an epitaxial layer 7 having n doping, on which, after oxidation and definition of active areas, there is executed a growth of gate oxide 8 and subsequently a deposition of polycrystalline silicon 9 suitable for the constitution, after n+ doping, of the power transistor's gate (Fig. 1).

After suitable masking with resist 10 (Fig. 1) there is executed in succession the etching of the polycrystalline silicon 9 and of the gate oxide 8 for the definition of a gate region 15, followed by the implantation and diffusion of n-dopant (say, boron) for the creation of low-doping body regions 12 (Fig. 2).

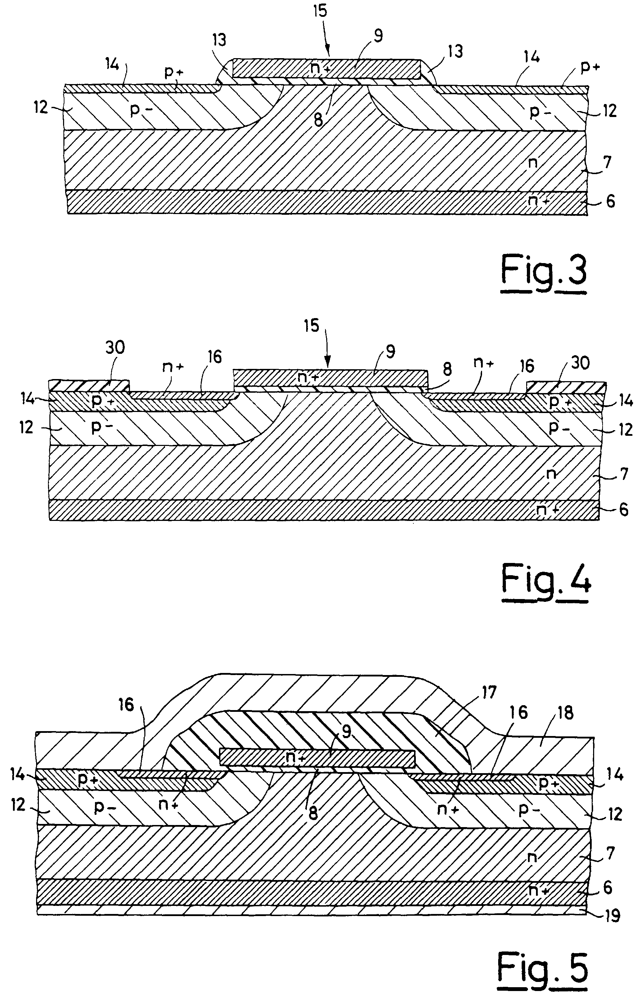

A subsequent step of the process, illustrated in Fig. 3, provides for the formation of spacers 13 (of oxide or other appropriate material) at the sides of the polycrystalline silicon 9, followed by implantation and diffusion of p+ dopant for the creation of high-doping body regions 14 self-aligned with gate 9 and wholly contained inside the low-doping body regions 12.

Subsequently, as illustrated in Fig. 4, the removal is executed of spacers 13 and then, after formation of oxide areas 30, the implantation and diffusion of arsenic for the creation of source regions 16 of the n+ type. Oxide 30 is subsequently removed.

Gate 9 is then covered with an insulating layer 17 and, after the formation of contact areas, there are executed the metallizations of the front and of the rear of the device, indicated in Fig. 5 with 18 and 19, respectively.

There is thus obtained an MOS type power transistor with a vertical current flow which has the high-doping body regions 14 contained inside the low-doping body regions 12 and self-aligned with gate 9.

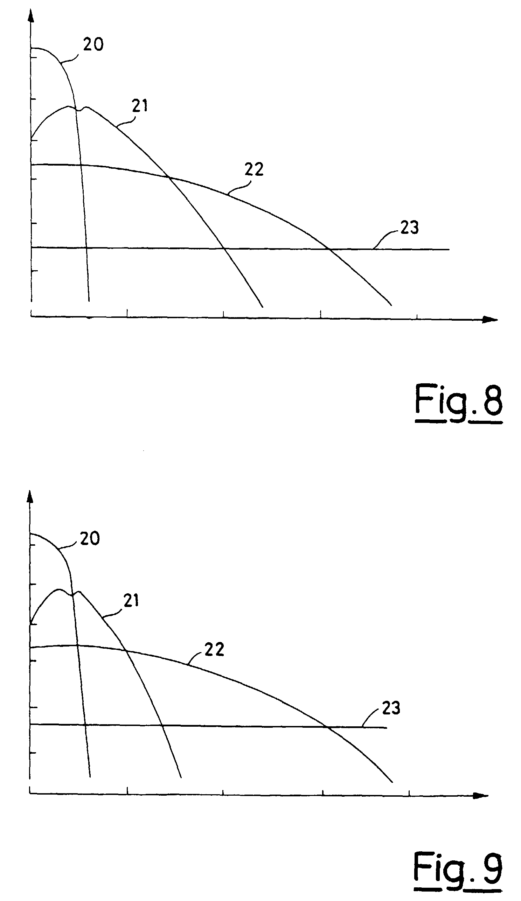

Possible concentration profiles of the various layers of the transistor are illustrated in the diagram of Fig. 8, where the x-axis gives the junction depths (in microns) starting from the surface and the y-axis gives the log values of the dopant concentrations (in atoms/cm³).

Four curves 20, 21, 22, 23 are represented in succession, wherein curve 20 represents the logarithm of the concentration of arsenic in the source regions 16, curve 21 represents the logarithm of the concentration of boron in the high-doping regions 14, curve 22 represents the logarithm of the concentration of boron in the low-doping regions regions 12, curve 23 represents the logarithm of the concentration of phosphorus in the epitaxial layer 7.

It is possible to see from the above diagram that the junction depth of the high-doping regions 14 is less than that of the low-doping regions 12.

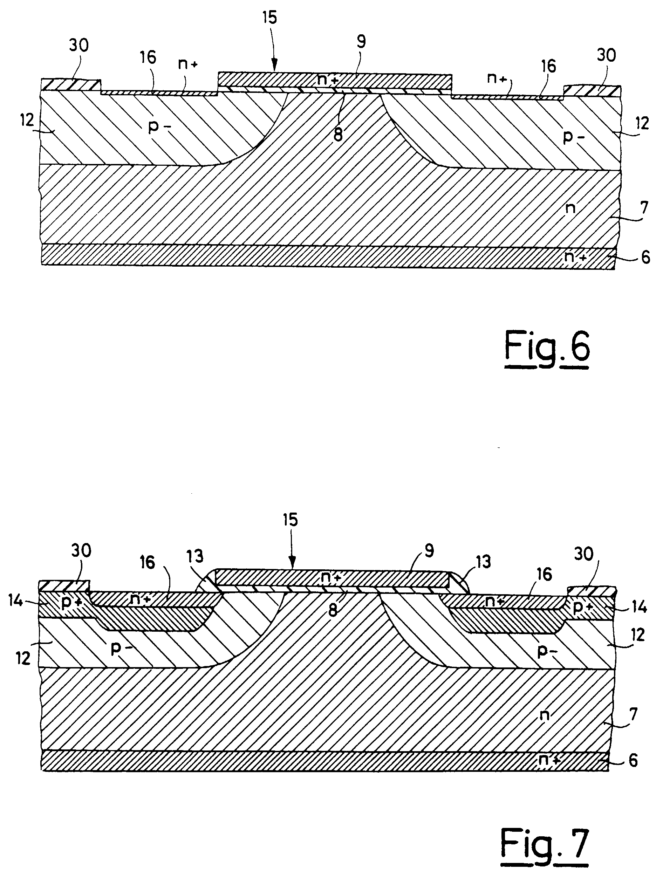

As illustrated in Fig.s 6 and 7, an embodiment of the process according to the invention provides, after the implantation and the diffusion of low-doping regions 12, that is after the situation illustrated in Fig 2 and instead of the steps illustrated in Fig.s 3 and 4, for the execution in succession of the implantation of the source regions 16 (Fig. 6), the formation of spacers 13, the implantation of the high-doping regions 14, the simultaneous diffusion of the source regions 16 and of the high-doping regions 14 (Fig. 7) and the removal of spacers 13. The process proceeds and then ends as in the previous case, determining the production of a transistor similar to that of Fig. 5.

Fig. 9 shows the concentration/depth diagram obtained with the embodiment of Fig.s 6 and 7. As can be seen, the junction depth of the high-doping regions 14 is even less than that obtainable with the process of Fig.s 1 to 5.

While reference is made in the drawings, as an example, to n channel transistors, it is evident that the process according to the invention, in its alternative embodiments, can also be applied for the accomplishment of p channel MOS transistors.

Moreover, such a process, described for discrete devices, can also be applied to integrated devices, such as, say, monolithic circuits comprising a control circuit and a power stage.

## Claims

1. Process for manufacturing power MOS transistors with vertical current flow, comprising the steps of:
a) growing an epitaxial layer (7) with a low concentration of dopant of a first type of conductivity on a silicon substrate (6) having a high concentration of dopant of the same type;
b) forming field oxide regions;
c) masking and defining of active areas on the surface of the epitaxial layer (7);
d) growing gate oxide (8);
e) depositing a polycrystalline silicon layer (9) and doping it with a high concentration of dopant of the first type;
f) masking and etching the polycrystalline silicon Layer (9) and the gate oxide (8) to define a gate electrode (15);
g) implanting and diffusing dopant of a second type of conductivity to form lightly doped body regions (12) at the sides and partially below said gate electrode (15);
characterized by the further successive steps of:
h) implanting dopant of the first type of conductivity to form source regions (16) above said lightly doped body regions (12);
i) forming spacers (13) at the sides of the gate electrode (15);
j) implanting a high concentration of dopant of the second type of conductivity to form heavily doped body regions (14) lying wholly inside said lightly doped body regions (12) below the source regions (16) and aligned with the gate electrode (15);
k) diffusing the dopants of said source regions (16) and said heavily doped body regions (14);
I) removing the spacers (13).

## Patentansprüche

1. Verfahren zum Herstellen von MOS-Leistungstransistoren mit vertikalem Stromfluß, mit folgenden Schritten:
a) Aufwachsen einer Epitaxieschicht (7) mit einer niedrigen Konzentration eines Dotierstoffs eines ersten Leitfähigkeits-Typs auf einem Siliziumsubstrat (6) mit einer hohen Konzentration von Dotierstoff desselben Typs;
b) Bilden von Feldoxidbereichen;
c) Maskieren und Definieren von aktiven Bereichen auf der Oberfläche der Epitaxieschicht (7);
d) Aufwachsen von Gateoxid (8);
e) Aufbringen einer polykristallinen Siliziumschicht (9) und Dotieren derselben mit einer hohen Konzentration von Dotierstoff des ersten Typs;
f) Maskieren und Ätzen der polykristallinen Siliziumschicht (9) und des Gateoxids (8) zur Bildung einer Gateelektrode (15);
g) Implantieren und Eindiffundieren von Dotierstoff eines zweiten Leitfähigkeits-Typs zur Bildung schwach dotierter Körperbereiche (12) an den Seiten und teilweise unter der Gateelektrode (15);
**gekennzeichnet durch** die weiteren darauf folgenden Schritte:
h) Implantieren von Dotierstoff des ersten Leitfähigkeits-Typs zur Bildung von Sourcebereichen (16) über den schwach dotierten Körperbereichen (12);
i) Bilden von Abstandselementen (13) an den Seiten der Gateelektrode (15);
j) Implantieren einer hohen Konzentration von Dotierstoff des zweiten Leitfähigkeits-Typs zur Bildung stark dotierter Körperbereiche (14), die vollständig innerhalb der schwach dotierten Körperbereiche (12) unter den Sourcebereichen (16) liegen und mit der Gateelektrode (15) ausgerichtet sind;
k) Eindiffundieren der Dotierstoffe der Sourcebereiche (16) und der stark dotierten Körperbereiche (14);
l) Entfernen der Abstandselemente (13).

## Revendications

1. Procédé de fabrication de transistors MOS de puissance à circulation de courant verticale comprenant les étapes suivantes :
a) faire croître une couche épitaxiale (7) à faible concentration de dopant d'un premier type de conductivité sur un substrat de silicium (6) à forte concentration de dopant du même type
b) former des régions d'oxyde de champ ;
c) masquer et définir des zones actives à la surface de la couche épitaxiale (7) ;
d) faire croître un oxyde de grille (8)
e) déposer une couche de silicium polycristallin (9) et la doper à forte concentration de dopant du premier type ;
f) masquer et graver la couche de silicium polycristallin (9) et l'oxyde de grille (8) pour définir une électrode de grille (15) ;
g) implanter et faire diffuser un dopant du second type de conductivité pour former des régions de corps faiblement dopées (12) sur les côtés et partiellement en dessous de l'électrode de grille (15) ;
caractérisé par les étapes supplémentaires successives suivantes :
h) implanter un dopant du premier type de conductivité pour former des régions de source (16) au-dessus des régions de corps faiblement dopées (12) ;
i) former des espaceurs (13) sur les côtés des électrodes de grille (15) ;
j) implanter un dopant à forte concentration du second type de conductivité pour former des régions de corps fortement dopées (14) se trouvant complètement dans les régions de corps faiblement dopées (12), sous les régions de source (16) et de façon alignée avec les électrodes de grille (15) ;
k) faire diffuser les dopants des régions de source (16) et des régions de corps fortement dopées (14)
l) enlever les espaceurs (13).
